**Europäisches Patentamt**

**European Patent Office**

**Office européen des brevets**

(19)

(11) Publication number : **0 419 819 B1**

## (12) EUROPEAN PATENT SPECIFICATION

(45) Date of publication of patent specification :
**02.06.93 Bulletin 93/22**

(51) Int. Cl.⁵ : **G05F 3/26**

(21) Application number : **90115278.5**

(22) Date of filing : **09.08.90**

(54) **Current mirror.**

(30) Priority : **27.09.89 GB 8921799**

(43) Date of publication of application :
**03.04.91 Bulletin 91/14**

(45) Publication of the grant of the patent :
**02.06.93 Bulletin 93/22**

(84) Designated Contracting States :
**DE FR GB IT NL SE**

(56) References cited :
**GB-A- 2 086 682**
**US-A- 4 166 971**
**US-A- 4 345 216**
**US-A- 4 525 683**
**US-A- 4 647 870**
**US-A- 4 831 337**

(73) Proprietor : **MOTOROLA, INC.**
**1303 East Algonquin Road**
**Schaumburg, IL 60196 (US)**

(72) Inventor : **Gay, Michael John**
**19 Chemin de la Source**
**Coppet, Vaud 1296 (CH)**

(74) Representative : **Dunlop, Hugh Christopher et al**
**Motorola European Intellectual Property Operations Jays Close Viables Industrial Estate**
**Basingstoke, Hampshire RG22 4PD (GB)**

EP 0 419 819 B1

## Description

This invention relates to current mirrors and particularly to a low-voltage current mirror realised in bipolar technology.

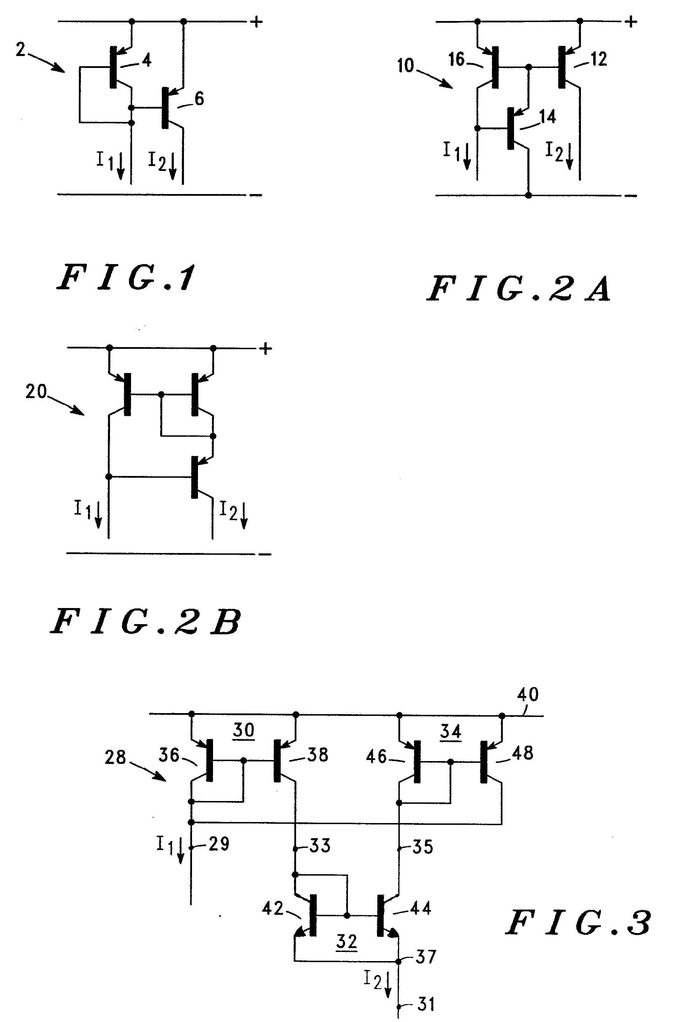

Simple current mirrors, for example the simple current mirror 2 shown in Figure 1, are well known in the art. However, such arrangements are often insufficiently accurate, particularly when realised with low gain elements such as two lateral pnp transistors 4 and 6. The ratio of output current I2 to input current I1 of the simple current mirror 2 is given by:

$$\frac{I_2}{I_1} = \frac{1}{1 + \frac{2}{\beta}} \quad (1)$$

where $\beta$ is the current gain of the pnp transistors. Thus, for small values of the $\beta$ accuracy of the simple current mirror is poor.

Two circuits 10 and 20 which are commonly used to resolve this problem are shown in Figures 2a and 2b. However, these circuits have a major disadvantage in that two base/emitter junctions are in series at the input node, for example the base/emitter junctions of transistors 12 and 14 of Figure 2a, which doubles the input voltage required compared with the simple current mirror of Figure 1.

In addition, since the current mirror 10 of Figure 2a has a transistor 14 biassed only by the base current of transistors 12 and 16, the current mirror 10 can suffer from slew-rate problems.

UK Patent Application No. GB-A-2086682 describes a cascade arrangement of current mirror amplifiers.

It is an object of the present invention to provide an improved current mirror wherein the above disadvantages are overcome.

In accordance with the present invention there is provided a current mirror circuit comprising:

an input node;

a first simple current mirror of a first semiconductor type having an input coupled to said input node and an output;

a second simple current mirror of a second semiconductor type having an input coupled to said output of said first simple current mirror and an output;

a third simple current mirror of said first semiconductor type having an input coupled to said output of said second simple current mirror; and

an output node coupled to said second simple current mirror so as to receive the sum of the input and output currents of said second simple current mirror flowing in a common terminal thereof, the current mirror circuit characterised in that the third simple current mirror has an output coupled to said input node.

In a preferred embodiment the first and third simple current mirrors comprise pnp type bipolar transistors and the second simple current mirror comprises npn type bipolar transistors. However, the complementary transistor type may also be used for each of the current mirrors.

The invention will now be more fully described, by way of example, with reference to the accompanying drawings in which:

Figure 1 shows a well known simple current mirror circuit;

Figures 2a and 2b show more complicated prior art current mirror circuits; and

Figure 3 shows a current mirror circuit according to the present invention.

The current mirror circuit 28 of Figure 3 comprises a first simple current mirror 30, a second simple current mirror 32 and a third simple current mirror 34. In a preferred embodiment, the first current mirror 30 and third current mirror 34 are of pnp type and the second current mirror 32 is of npn type.

The first current mirror 30 comprises first and second pnp transistors 36 and 38. The first transistor 36 is coupled as a diode. The emitter electrode of the first transistor 36 is coupled together with the emitter electrode of the second transistor to a positive supply line 40 and the base electrodes of the first and second transistors are coupled together. The collector electrode of the first transistor 36 forms the input of the first current mirror 30 which is coupled to an input node 29 and the collector electrode of the second transistor 38 forms the output of the first current mirror 30 which is coupled to an input of the second current mirror 32 at node 33.

The second current mirror 32 comprises first and second npn transistors 42 and 44. The first transistor 42 is coupled as a diode. The emitter electrode of the first transistor 42 is coupled together with the emitter electrode of the second transistor 44 to a common terminal 37 connected to an output node 31. The base electrodes of the first and the second transistors are coupled together. The collector electrode of the first transistor 42 forms the input of the second current mirror 32 and the collector electrode of the second transistor 44 forms the output of the second current mirror 32 which is coupled to an input of the third current mirror 34 at node 35.

The third current mirror 34 comprises third and fourth pnp transistors 46 and 48. The third transistor 46 is coupled as a diode. The emitter electrode of the third transistor 46 is coupled together with the emitter electrode of the second transistor 48 to the positive supply line 40 and the base electrodes of the third and fourth transistors are coupled together. The collector electrode of the third transistor 46 forms the input of the third current mirror 34 and the collector electrode of the fourth transistor 48 forms the output of the third current mirror 34 which is coupled to the input node 29.

Elementary analysis will show that if the current gains of the mirrors 30, 32 and 34 are M1, M2 and M3 respectively, then the overall current gain, that is the ratio of the output current I2 to the input current I1, of the circuit 28 will be given by:

$$\frac{I_2}{I_1} = \frac{M1\,(1 + M2)}{1 + M1\,M2\,M3} \quad (2)$$

If the gains of the pnp and npn current mirrors are respectively,

$$\frac{1}{1 + 2/\beta p} \quad (3)$$

and

$$\frac{1}{1 + 2/\beta \eta} \quad (4)$$

then the overall gain of the circuit is:

$$\frac{I_2}{I_1} = 2\,\frac{\left(1 + \dfrac{1}{\beta \eta}\right)\left(1 + \dfrac{2}{\beta p}\right)}{1 + \left(1 + \dfrac{2}{\beta \eta}\right)\left(1 + \dfrac{2}{\beta p}\right)^2} \quad (5)$$

Rearranging this equation gives:

$$\frac{I_2}{I_1} = \cfrac{1}{1 + 2\,\cfrac{\left(\dfrac{1}{\beta \eta} + \dfrac{1}{\beta p} + \dfrac{2}{\beta \eta\,\beta p}\right)}{\beta p\left(1 + \dfrac{1}{\beta \eta}\right)\left(1 + \dfrac{2}{\beta p}\right)}} \quad (6)$$

$$\approx \cfrac{1}{1 + \dfrac{2}{\beta p}\left(\dfrac{1}{\beta \eta} + \dfrac{1}{\beta p}\right)} \quad (7)$$

Thus, the gain error is reduced, compared with the simple mirror (equation (1)) by a factor,

$$\frac{\beta \eta\,\beta \eta}{\beta \eta + \beta p} \quad (8)$$

It will be seen by inspection of Figure 3 that any variations in the voltage applied at the output node 31 appear only between the emitter and collector terminals of transistors 38 and 44. The gains M1, M2 of the first 30 and second 32 current mirrors respectively are consequently modified, by the Early effect, in response to the voltage applied at the output node 31, causing the circuit to have a finite output impedance. Referring to equation 2, and assuming the current mirrors to have unity nominal gain (i.e. M1, M2, M3=1) as in the preferred embodiment, it will be seen that variations in M2 have little effect on the overall gain which varies however according to approximately half the variation in M1. It therefore follows that the output impedance of the circuit is approximately twice that of the impedance of the first current mirror 30. Since the first current mirror 30 operates at approximately one half of the input current I1 as do the second and third current mirrors 32 and 34, it follows that the output impedance of the current mirror circuit 28 will be approximately four times that of a simple current mirror 2 shown in Figure 1.

The current mirror circuit according to the present invention is unconditionally stable since the open loop gain of the feedback loop is unity. In addition, there are no slew-rate problems since all the devices operate at approximately half the input current.

In summary, the present invention provides a current mirror circuit requiring low input voltages and having a high output impedance. The feedback arrangement of the invention reduces the gain error and thus provides for an improved current mirror circuit wherein the output current will more accurately mirror the input current.

It will be appreciated by those skilled in the art that although the invention has been described wherein the first and third current mirrors are of pnp type and the second current mirror is of npn type, the invention may be realised equally with the pnp current mirrors replaced by npn current mirrors and the npn current mirror with a pnp current mirror.

## Claims

1. A current mirror circuit comprising:
   an input node (29);
   a first simple current mirror (30) of a first semiconductor type having an input coupled to said input node (29) and an output (33)
   a second simple current mirror (32) of a second semiconductor type having an input coupled to said output (33) of said first simple current mirror and an output;
   a third simple current mirror (34) of said first semiconductor type having an input (35) coupled to said output of said second simple current mirror; and
   an output node (31) coupled to said second simple current mirror (32) so as to receive the sum of the input and output currents of said second simple current mirror (32) flowing in a common terminal (37) thereof, the current mirror circuit characterised in that the third simple current mirror (34) has an output coupled to said input node (29).

2. A current mirror circuit according to claim 1 wherein said second simple current mirror (32) comprises first (42) and second (44) transistors having a common base electrode, the collector electrode of said first transistor (42) is coupled to said common base electrode and forms the input of said second simple current mirror, the collector electrode of said second transistor (44) forms the output of said second simple current mirror, and the emitter electrodes of said first and second transistors are coupled together to said common terminal (37), which is coupled to said output node of said current mirror circuit.

3. A current mirror circuit according to claim 1 or 2 wherein said first simple current mirror (30) comprises third (36) and fourth (38) transistors having a common base electrode, the collector electrode of said third transistor (36) is coupled to said common base electrode and forms the input of said first simple current mirror, the collector electrode of said fourth transistor (38) forms the output of said first simple current mirror, and the emitter electrodes of said third and fourth transistors are coupled together to a first reference potential line (40).

4. A current mirror circuit according to claim 1, 2 or 3 wherein said third simple current mirror (34) comprises fifth (46) and sixth (48) transistors having a common base electrode, the collector electrode of said fifth transistor (46) is coupled to said common base electrode and forms the input of said third simple current mirror, the collector electrode of said sixth transistor (48) forms the output of said third simple current mirror, and the emitter electrodes of said fifth and sixth transistors are coupled together to a first reference potential line (40).

5. A current mirror circuit according to claim 1, 2, 3 or 4 wherein said first semiconductor type comprises npn bipolar technology and said second semiconductor type comprises pnp bipolar technology.

6. A current mirror circuit according to claim 1, 2, 3 or 4 wherein said first semiconductor type comprises pnp bipolar technology and said second semiconductor type comprises npn bipolar technology.

## Patentansprüche

1. Ein Stromspiegelschaltkreis umfassend

4

einen Eingangsknoten (29);

einen ersten einfachen Stromspiegel (30) eines ersten Halbleitertyps, der einen mit dem genannten Eingangsknoten (29) gekoppelten Eingang und einen Ausgang (33) aufweist;

einen zweiten, einfachen Stromspiegel (32) eines zweiten Halbleitertyps, der einen mit dem genannten Ausgang (33) des genannten ersten, einfachen Stromspiegels gekoppelten Eingang und einen Ausgang aufweist;

einen dritten, einfachen Stromspiegel (34) des genannten ersten Halbleitertyps, der einen mit dem genannten Ausgang des genannten zweiten, einfachen Stromspiegels gekoppelten Eingang hat; und

einen Ausgangsknoten (31), der mit dem genannten zweiten, einfachen Stromspiegel (32) gekoppelt ist, damit er die Summe des Eingangsstroms und des Ausgangsstroms des genannten zweiten einfachen, Stromspiegels (32) erhält, der in eine gemeinsame Klemme (37) desselben fließt, wobei der Stromspiegelschaltkreis dadurch gekennzeichnet ist, daß der dritte, einfache Stromspiegel (34) einen mit dem genannten Eingangsknoten (29) gekoppelten Ausgang hat.

2. Ein Stromspiegelschaltkreis gemäß Anspruch 1, bei dem der genannte zweite, einfache Stromspiegel (32) umfaßt einen ersten (42) und einen zweiten (44) Transistor, die eine gemeinsame Basiselektrode haben, wobei die Kollektorelektrode des genannten ersten Transistors (42) mit der genannten gemeinsamen Basiselektrode gekoppelt ist und den Eingang des genannten zweiten, einfachen Stromspiegels bildet, die Kollektorelektrode des genannten zweiten Transistors (44) den Ausgang des genannten zweiten, einfachen Stromspiegels bildet und die Emitterelektroden des genannten ersten und zweiten Transistors zusammen mit der genannten gemeinsamen Klemme (37) gekoppelt sind, die mit dem genannten Ausgangsknoten des genannten Stromspiegelschaltkreises gekoppelt ist.

3. Ein Stromspiegelschaltkreis gemäß Anspruch 1 oder 2, bei dem der genannte erste, einfache Stromspiegel (30) umfaßt einen dritten (36) und vierten (38) Transistor, die eine gemeinsame Basiselektrode haben, wobei die Kollektorelektrode des genannten dritten Transistors (36) mit der genannten gemeinsamen Basiselektrode gekoppelt ist und den Eingang des genannten ersten, einfachen Stromspiegels bildet, die Kollektorelektrode des genannten vierten Transistors (38) den Ausgang des genannten ersten, einfachen Stromspiegels bildet und die Emitterelektroden des genannten dritten und vierten Transistors zusammen mit einer ersten Bezugspotentialleitung (40) gekoppelt sind.

4. Ein Stromspiegelschaltkreis gemäß Anspruch 1, 2 oder 3, bei dem der genannte dritte, einfache Stromspiegel (34) einen fünften (46) und einen sechsten (48) Transistor umfaßt, die eine gemeinsame Basiselektrode haben, wobei die Kollektorelektrode des genannten fünften Transistors (46) mit der genannten gemeinsamen Basiselektrode gekoppelt ist und den Eingang des genannten dritten, einfachen Stromspiegels bildet, die Kollektorelektrode des genannten sechsten Transistors (48) den Ausgang des genannten dritten, einfachen Stromspiegels bildet und die Emitterelektroden des fünften und des sechsten Transistors zusammen mit einer ersten Bezugspotentialleitung (40) gekoppelt sind.

5. Ein Stromspiegelschaltkreis gemäß Anspruch 1, 2, 3 oder 4, bei dem der genannte erste Halbleitertyp eine npn bipolare Technologie und der genannte zweite Halbleitertyp eine pnp bipolare Technologie umfaßt.

6. Ein Stromspiegelschaltkreis gemäß Anspruch 1, 2, 3 oder 4, bei dem der genannte erste Halbleitertyp eine pnp bipolare Technologie und der genannte zweite Halbleitertyp eine npn bipolare Technologie umfaßt.

**Revendications**

1. Circuit miroir de courant comprenant :

un noeud d'entrée (29) ;

un premier miroir de courant simple (30) d'un premier type de semiconducteur comportant une entrée couplée audit noeud d'entrée (29) et une sortie (33) ;

un second miroir de courant simple (32) d'un second type de semiconducteur comportant une entrée couplée à ladite sortie (33) dudit premier miroir de courant simple et une sortie ;

un troisième miroir de courant simple (34) dudit premier type de semiconducteur comportant une entrée (35) couplée à ladite sortie dudit second miroir de courant simple ; et

un noeud de sortie (31) couplé audit second miroir de courant simple (32) de manière à recevoir la somme des courants d'entrée et de sortie dudit second miroir de courant simple (32) circulant dans une borne commune (37) de celui-ci, le circuit miroir de courant étant caractérisé en ce que le troisième miroir de courant simple (34) comporte une sortie couplée audit noeud d'entrée (29) .

2. Circuit miroir de courant selon la revendication 1, dans lequel ledit second miroir de courant simple (32) comprend des premier (42) et second (44) transistors comportant une électrode de base commune, l'électrode de collecteur dudit premier transistor (42) est couplée à ladite électrode de base commune et forme l'entrée dudit second miroir de courant simple, l'électrode de collecteur dudit second transistor (44) forme la sortie dudit second miroir de courant simple et les électrodes d'émetteur desdits premier et second transistors sont couplées ensemble à ladite borne commune (37), laquelle est couplée audit noeud de sortie dudit circuit miroir de courant.

3. Circuit miroir de courant selon la revendication 1 ou 2, dans lequel ledit premier miroir de courant simple (30) comprend des troisième (36) et quatrième (38) transistors comportant une électrode de base commune, l'électrode de collecteur dudit troisième transistor (36) est couplée à ladite électrode de base commune et forme l'entrée dudit premier miroir de courant simple, l'électrode de collecteur dudit quatrième transistor (38) forme la sortie dudit premier miroir de courant simple et les électrodes d'émetteur desdits troisième et quatrième transistors sont couplées ensemble à une première ligne de potentiel de référence (40).

4. Circuit miroir de courant selon la revendication 1, 2 ou 3, dans lequel ledit troisième miroir de courant simple (34) comprend des cinquième (46) et sixième (48) transistors comportant une électrode de base commune, l'électrode de collecteur dudit cinquième transistor (46) est couplée à ladite électrode de base commune et forme l'entrée dudit troisième miroir de courant simple, l'électrode de collecteur dudit sixième transistor (48) forme la sortie dudit troisième miroir de courant simple et les électrodes d'émetteur desdits cinquième et sixième transistors sont couplées ensemble à une première ligne de potentiel de référence (40).

5. Circuit miroir de courant selon la revendication 1, 2, 3 ou 4, dans lequel ledit premier type de semiconducteur comprend une technologie bipolaire NPN et ledit second type de semiconducteur comprend une technologie bipolaire PNP.

6. Circuit miroir de courant selon la revendication 1, 2, 3 ou 4, dans lequel ledit premier type de semiconducteur comprend une technologie bipolaire PNP et ledit second type de semiconducteur comprend une technologie bipolaire NPN.

*FIG.1*

*FIG.2A*

*FIG.2B*

*FIG.3*